# EUROPEAN PATENT SPECIFICATION

(11) **EP 0 419 062 B1**
(45) Date of publication and mention of the grant of the patent: **23.07.1997**
(21) Application number: 90309456.3
(22) Date of filing: 29.08.1990
(51) Int. Cl.: H01L 21/285

(54) **Method of forming an Ohmic electrode on an GaAlAs layer**
Verfahren zur Herstellung einer Ohmschen Elektrode auf einer GaAlAs Schicht
Procédé pour la fabrication d'une electrode ohmique sur une couche de GaAlAs

(30) Priority: 30.08.1989 JP 225903/89
(43) Date of publication of application: 27.03.1991
(73) Proprietor: Mitsubishi Chemical Corporation, Chiyoda-ku Tokyo (JP)
(72) Inventor: Ibuka, Toshihiko, c/o Mitsubishi Kasei Polytec Co., Ushiku-shi, Ibaraki 300-12 (JP); Noguchi, Masahiro, c/o Mitsubishi Kasei Polytec Co, Ushiku-shi, Ibaraki 300-12 (JP)
(74) Representative: Dixon, Donald Cossar

(56) References cited:
- EP-A- 0 323 554
- WO-A-83/03713
- DE-C- 2 359 640
- WORLD PATENT INDEX DATABASE WPIL, ACCESSION-NO. 86-309 905 Ä 47 Ü DERWENT PUBLICATIONS LTD., London & JP-A-55-030 834
- WORLD PATENT INDEX DATABASE WPIL, ACCESSION-NO. 76-060 81X DERWENT PUBLICATIONS LTD., London & JP-A-50 063 877
- WORLD PATENT INDEX DATABASE WPIL, ACCESSION-NO. 80-510 14C DERWENT PUBLICATIONS LTD., London & JP-A-49 115 772
- PATENT ABSTRACTS OF JAPAN, unexamined applications, E section, vol. 1, no. 156, December 13, 1977 THE PATENT OFFICE JAPANESE GOVERNMENT
- PATENT ABSTRACTS OF JAPAN, unexamined applications, E section, vol. 2, no. 99, August 17, 1978 THE PATENT OFFICE JAPANESE GOVERNMENT
- PATENT ABSTRACTS OF JAPAN, unexamined applications, E section, vol. 2, no. 55, April 21, 1978 THE PATENT OFFICE JAPANESE GOVERNMENT
- PATENT ABSTRACTS OF JAPAN, unexamined applications, E section, vol. 5, no. 197, December 15, 1981 THE PATENT OFFICE JAPANESE GOVERNMENT

## Description

The present invention relates to a method of forming an electrode from a semiconductor compound.

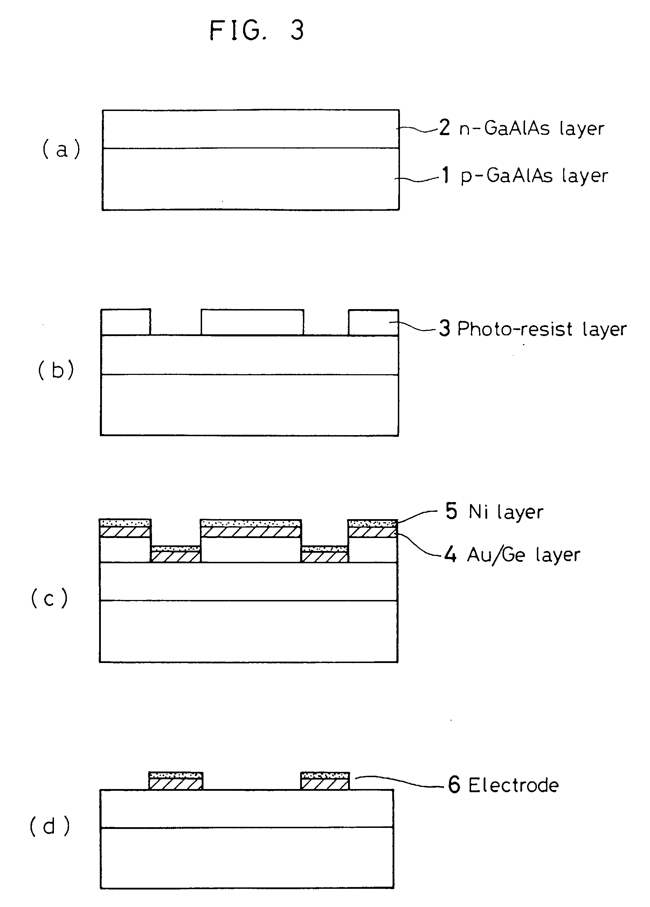

In the conventional method to form an ohmic electrode of a semiconductor compound such as n-type GaAs or GaAlAs, in order to form the product in desirable form on the semiconductor substrate, a photoresist pattern is formed on the n-type layer surface in many cases, and vacuum evaporation is performed by a resistance heating method with an alloy of Au and Ge as vacuum evaporation source and Ni is vacuum-deposited by a resistance heating method or by electron beam deposition method. Namely, as shown in Fig. 3, the pattern 3 is formed (Fig. 3(b)) using a photo-resist on n-GaAlAs 2 formed on p-GaAlAs 1. Then, the electrode materials Au/Ge layer 4 and Ni layer 5 are vacuum-deposited on the entire surface (Fig. 3(c)), and undesired portions are removed by a lift-off method, and thus the electrode pattern 6 is formed as shown in Fig. 3(d). In order to obtain an ohmic property after electrode materials are vacuum-deposited, an alloying treatment is performed by heating at 400 to 500°C in a nitrogen or hydrogen atmosphere.

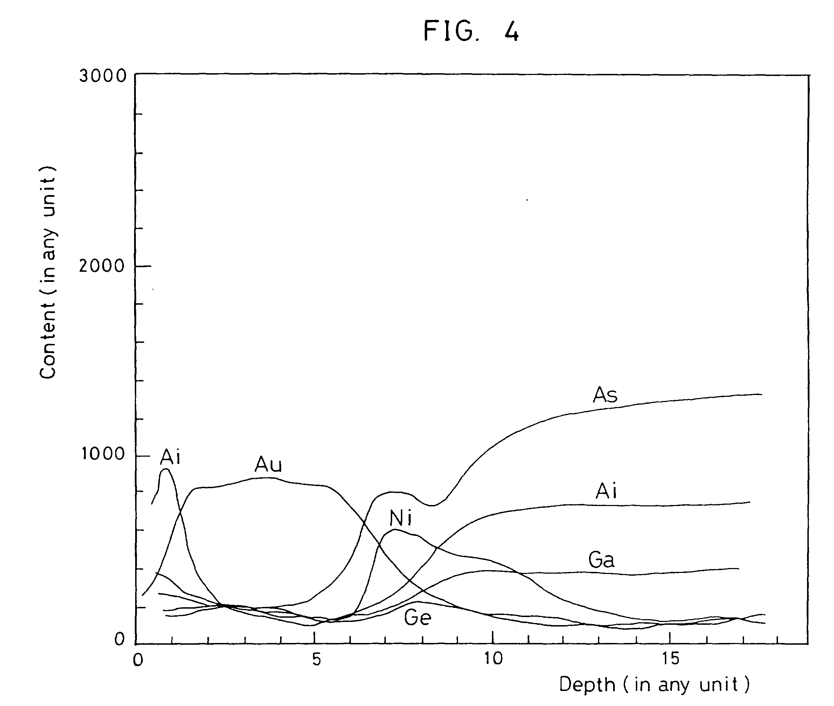

A composition profile from below electrode surface was obtained on such a conventional type of Au-Ge/Ni electrode using SIMS (secondary ion mass spectrometry), and the results were as shown in Fig. 4. In the figure, the abscissa represents the depth from electrode surface (in any unit), and the ordinate the component strength (in any unit).

In the figure, the depth with equal strength of Au and Ga approximately corresponds to the interface between electrode and semiconductor, and the Ni content at this position is as high as 23.8 wt %. A natural oxide film is present on the AlGaAs surface, and a Au-Ge solution is aggregated on the portion without oxide film, causing the irregular alloying (the so-called ball-up phenomenon). Because Ni shows a strong solid phase reaction with GaAs, a part of the Ni is diffused to the AlGaAs interface. Thus, GaAs is decomposed in the solid phase, and compounds such as NiAs or β-AuGa are formed. By this solid phase reaction, the natural oxide film on the AlGaAs semiconductor surface is removed, and this prevents the ball-up phenomenon. In a Au-Ge/Ni electrode made by a conventional method, Ni is diffused in large quantity to the AlGaAs layer as is evident from Fig. 4 to prevent ball-up, and it is necessary to vacuum-deposit Ni in large quantity. Also, Al is piled up on the electrode layer surface. Because Al is easily oxidized and is turned to insulating material when oxidized, contact resistance is increased, and ohmic property is lost in some cases.

In the conventional method, when the mixed crystal ratio x of Al in n-type Gaₗ₋ₓAlₓ As (0 ≦ x ≦ 1) or n-type Gaₗ₋ₓAlₓ As with low carrier density is 0.5 or more, the contact resistance is not sufficiently low. If the alloy temperature is set at a higher value in order to decrease contact resistance, ball-up phenomenon occurs; irregularities are found on the surface of the vacuum-deposited metal, and detachment occurs during wire bonding.

The present invention is intended to solve the above problems.

The object of the present invention is to form an ohmic electrode having low contact resistance and developing no ball-up phenomenon.

The present inventors have found that the above object can be attained by controlling the sequence of vacuum-deposition of Au, Ga and Ni and the thickness of vacuum-deposited film of these substances.

The method of the invention of forming an ohmic electrode of formula Gaₗ₋ₓAlₓAs (0 ≦ x ≦ 1) comprises using Au, Ge and Ni as electrode materials, (1) wherein the Ni content in the interface between electrode and semi-conductor is 20 wt % or less; (2) preferably the Al component on electrode surface is 3 wt % or less; and (3) on the n-type layer surface of a compound semi conductor having n-type layer, Au is vacuum-deposited in a thickness of 10 - 200 Å as a first layer, 50 - 200 Å of Ge is deposited as a second layer, 50 - 200 Å of Ni as a third layer, and 200 - 1000 Å of Au as a fourth layer. Then, heat treatment (alloying treatment) is performed at 350 to 500°C in an atmosphere of an inert gas such as hydrogen or nitrogen.

In the accompanying drawings:
Fig. 1 is a series of vertical sections to show a method of forming an ohmic electrode for a semiconductor compound according to the present invention;
Fig. 2 is a diagram representing the composition profile below the electrode surface as measured by SIMS on the electrode obtained by this invention;
Fig. 3 is a series of cross-sections to show a conventional method of forming an ohmic electrode for compound semiconductor; and
Fig. 4 is a profile diagram as in Fig. 2 of an electrode obtained by the conventional method.

As the semiconductor compound, the method is primarily applied on Gaₗ₋ₓ AlₓAs (0 ≦ x ≦ 1). It is particularly effective when the mixed crystal ratio of Al is as high as 0.5≦ x ≦ 0.9.

To obtain a good ohmic electrode, the sequence of vacuum deposition of Au, Ge and Ni is very important, and it is preferable that vacuum deposition is performed in the following sequence:
Au in the first layer, Ge in the second layer, Ni in the third layer and Au in the fourth layer.

The Au layer 10 of the first layer has the thickness within the range of 10 - 200 Å, or preferably, within the range of 100 - 150 Å. The thickness of the Ge layer 11 of the second layer is within the range 50 - 200 Å, or preferably, within the range of 100 - 150 Å. The thickness of Ni 12 of the third layer is within the range of 50 - 200 Å, or preferably within the range of 100-150 Å. The thickness of Au layer 13 of the fourth layer is within the range of 200 - 1000 Å, or preferably, within the range of 300 - 800 Å.

The temperature of heat treatment is preferably 350 to 500°C. If the temperature is too low, alloying is not performed to the full extent; if it is too high, the ball-up phenomenon occurs. As for the atmosphere during heat treatment, an inert gas such as H₂ or N₂ may be used, or application of partial pressure of a Group V element of the Periodic Table supplied by AsH₃ or the like can provide the similar effect.

The ohmic electrode having low contact resistance and developing no ball-up phenomenon can be obtained by the above procedure. To attach the electrode materials further onto a semiconductor compound surface, a resistance heating deposition method, electron beam deposition method or sputtering method may be used. When wiring is performed by mounting the semiconductor element to the heater of the device such as TO-18, an Au wire or Al wire is normally used for wire bonding. Because the ohmic electrode is thin and may be detached during wire bonding, a pad for the bonding is preferably formed on the ohmic electrode to increase the bonding property. It is preferable to use Au or Al as the pad for bonding; a Ni, Ti or Pt layer may be formed between the ohmic electrode and the Au or Al pad for bonding. In this case, heat treatment may be performed after the ohmic electrode material is deposited and the material for bonding is deposited.

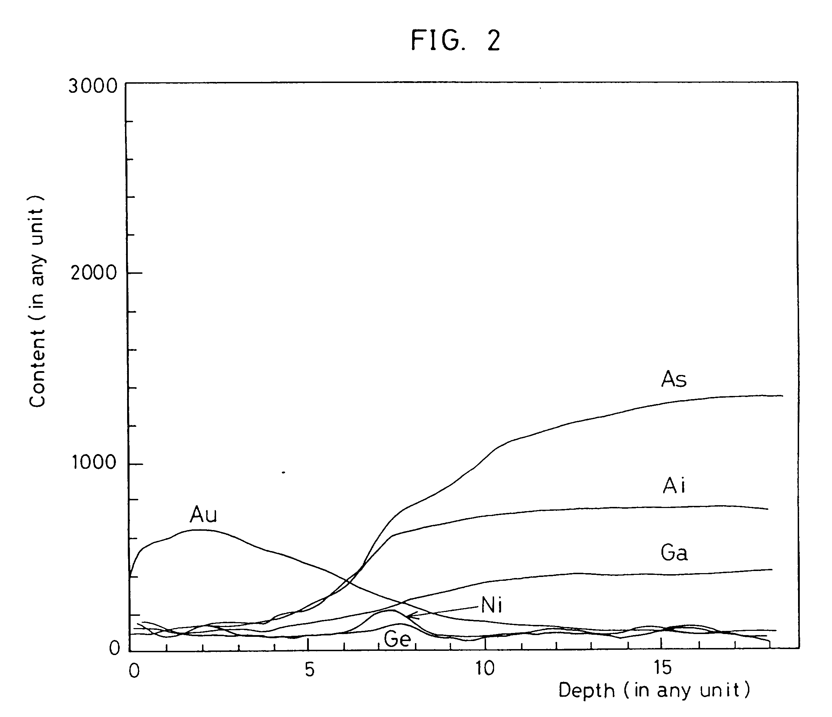

For the electrode obtained according to this invention, a composition profile from below the electrode surface was obtained by SIMS as in Fig. 4. The results are shown in Fig. 2.

As is evident from this figure, Ni has a peak value on the interface between electrode and semiconductor (the position where the strength of Au is equal to that of Ga), whereas its quantity is lower than in Fig. 4. In the measured example,it was 10 wt %. Thus, it is possible by this invention to suppress the ball-up phenomenon even when the Ni content is low. The Ni content on the interface is preferably 20 wt % or less, or more preferably, 15 wt % or less. An ohmic electrode having lower Al elution to electrode surface than in Fig. 4 can be formed. The Al content on the electrode surface is preferably 3 wt % or less.

The features of the invention will now be described by reference to an example and a comparative example.

### Example

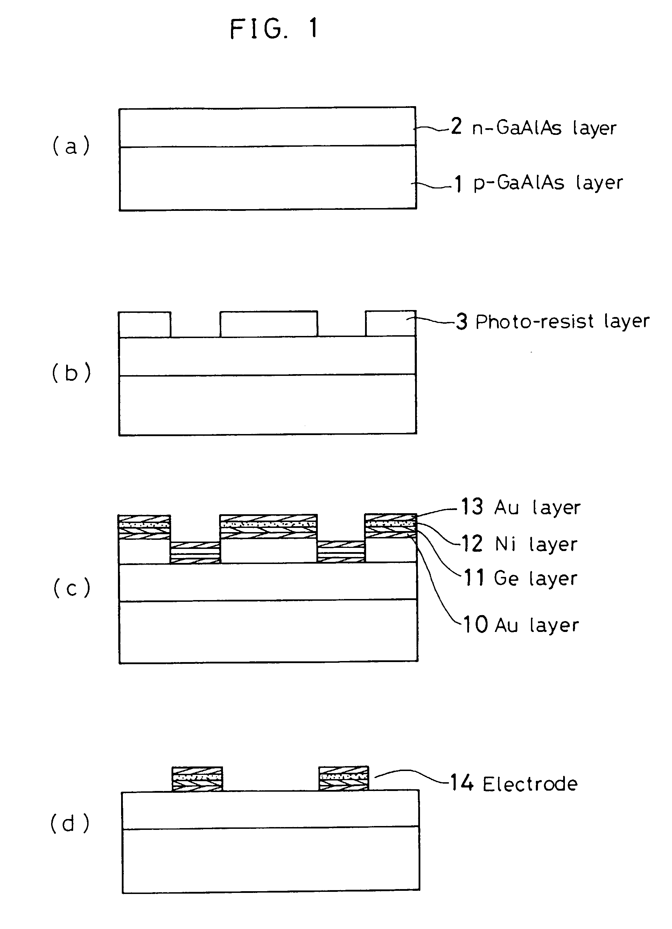

Double hetero structure epitaxial crystals of p-type Ga_{0.3}Al_{0.7}As, p-type Ga_{0.65}Al_{0.35} As and n-type Ga_{0.3} Al_{0.7} As was obtained by liquid phase epitaxy method on a p-type GaAs crystal as substrate. In this example, an expitaxial substrate was used, which has such a structure that p-type GaAs crystal is removed by polishing as shown in Fig. 1(a). The mixed crystal ratio of n-type epitaxial layer was x = 0.7, and the carrier density was 2 x 10¹⁸ cm⁻³.

Next, a lift-off method was used to form an electrode of the predetermined shape on the surface of the n-type Ga_{0.3} Al_{0.7}As. First, a photoresist film 3 was coated on the entire surface, and the photo resist film was then removed from only the electrode-forming portion by a photolithography method, as shown in Fig. 1(b). Next, as shown in Fig. 1(c), an Au layer 10 120 Å thick was vacuum-deposited as the first layer by an electron beam deposition method, a Ge layer 11 140 Å thick as the secondary layer, a Ni layer 12 140 Å thick as the third layer, and Au layer 13 700 Å thick as the fourth layer. After depositing each of these layers, the unrequired electrode portion was removed by a lift-off method, removing the photoresist film by acetone, and the electrode 14 of the shape as shown in Fig. 1(d) was formed. Then, heat treatment was performed at 420°C for 10 minutes in an atmosphere of N₂, and an electrode with smooth surface and developing no ball-up phenomenon was obtained. The contact resistance was as low as 5 x 10⁻⁵Ω cm², showing good ohmic property.

Further, to make a pad for bonding,a layer of Au 1 µm thick was deposited by a resistance heating method on the above ohmic electrode. After heat treatment was performed at 350°C for 5 minutes in an atmosphere of N₂ , an Au wire was attached by wire bonding. A good bonding property without detachment was obtained.

### Comparative Example

Using the same epitaxial substrate as used in the above example, an electrode was formed by a method of depositing an Au/Ge alloy and Ni as conventionally performed. The weight ratio of Au/Ge alloy was: Au 88% and Ge 12%.

After this Au/Ge alloy of thickness 2000 Å was deposited by a resistance heating method, a layer of Ni 200 Å thick was deposited by an electron beam deposition method. Next, heat treatment was performed at 380°C for 15 minutes in an atmosphere of N₂. Although ball-up did not occur, the contact resistance was as high as 2 x 10⁻³Ωcm². Then, heat treatment was performed at 430°C for 15 minutes. The contact resistance decreased to 7 x 10⁻⁴ Ω cm², but the ball-up phenomenon occurred, and extreme irregularities were were formed on the electrode surface.

As described above, it is possible according to the present invention to obtain an ohmic electrode on the surface of n-type Gaₗ₋ₓ Alₓ As, having good reproducibility, low contact resistance, smooth electrode surface and suffering no detachment during wire bonding. Thus, the invention is most useful as a method of forming an electrode for Gaₗ₋ₓ AlₓAs, which is to be used foran optical device or ultra-high speed electronic device such as high luminance light-emitting diode or semiconductor laser.

## Claims

1. A method of forming an ohmic electrode on an n-type Ga_{1-X}Al_{X}As(0≤x≤1) layer of a semiconductor device, wherein an Au layer is formed as a first layer on the surface of the n-type layer, and an alloying treatment is performed at a temperature of 350°-500°C after a Ge layer, a Ni layer and a Au layer are sequentially formed, characterised in that each layer has the following thickness:
1st layer Au 1-20mm (10-200 Å)
2nd layer Ge 5-20mm (50-200 Å)
3rd layer Ni 5-20mm (50-200 Å)
4th layer Au 20-100mm (200-1000 Å)

2. A method of forming a semiconductor electrode, characterised in that a pad for wire bonding consisting of Au or Al is formed on the ohmic electrode obtainable by the method of Claim 1.

3. A method according to Claim 1 or 2, wherein the ohmic electrode is formed by either electron beam deposition, resistance heating deposition or sputtering.

## Patentansprüche

1. Verfahren zur Herstellung einer Ohmschen Elektrode auf einer n-Typ-Ga₁₋ₓAlₓAs (0 ≤ x ≤ 1)-Schicht einer Halbleitervorrichtung, bei dem eine Au-Schicht als eine erste Schicht auf der Oberfläche der n-Typ-Schicht ausgebildet wird und eine Legierungsbehandlung bei einer Temperatur von 350 °C bis 500 °C durchgeführt wird, nachdem aufeinanderfolgend eine Ge-Schicht, eine Ni-Schicht und eine Au-Schicht ausgebildet wurden, dadurch gekennzeichnet, daß jede Schicht die folgende Dicke hat:
erste Schicht Au 1 - 20 nm (10 - 200 Å)
zweite Schicht Ge 5 - 20 nm (50 - 200 Å)
dritte Schicht Ni 5 - 20 nm (50 - 200 Å)
vierte Schicht Au 20 - 100 nm (200 bis 1000 Å).

2. Verfahren zur Herstellung einer Halbleiterelektrode, dadurch gekennzeichnet, daß eine aus Au oder Al bestehende Kontaktstelle für eine drahtgebundene Kontaktierung auf der durch das Verfahren nach Anspruch 1 erhaltbaren Ohmschen Elektrode ausgebildet wird.

3. Verfahren nach Anspruch 1 oder 2, bei dem die Ohmsche Elektrode durch Elektronenstrahl-Beschichtung, Widerstandsheiz-Beschichtung oder Sputtern ausgebildet wird.

## Revendications

1. Procédé de formation d'une électrode ohmique sur une couche de Ga₁₋ₓAlₓAs de type n (0 < x < 1) d'un dispositif semi-conducteur, dans lequel on forme une couche d'Au comme première couche à la surface de la couche de type n, et l'on réalise un traitement d'alliage à une température de 350-500°C après avoir formé successivement une couche de Ge, une couche de Ni et une couche d'Au, caractérisé en ce que chaque couche présente l'épaisseur suivante :
première couche d'Au 1-20 mm (10 - 200 Å)
deuxième couche de Ge 5-20 mm (50 - 200 Å)
troisième couche de Ni 5-20 mm (50 - 200 Å)
quatrième couche d'Au 20-100 mm (200 - 1000 Å)

2. Procédé de formation d'une électrode de semi-conducteur, caractérisé en ce qu'une patte pour la liaison d'un fil, constitué d'Au ou d'Al, est formée sur l'électrode ohmique que l'on peut obtenir par le procédé de la renvendication 1.

3. Procédé selon la revendication 1 ou 2, dans lequel l'électrode ohmique est formée par dépôt par faisceau d'électrons, par chauffage par résistance ou par pulvérisation.
